Europäisches Patentamt

European Patent Office

Office européen des brevets

(11) Publication number: **0 671 611 A2**

# EUROPEAN PATENT APPLICATION

(21) Application number: **94308518.3**

(51) Int. Cl.6: **G01H 9/00**

(22) Date of filing: **18.11.94**

(30) Priority: **10.03.94 US 209295**

(43) Date of publication of application:
**13.09.95 Bulletin 95/37**

(84) Designated Contracting States:
**DE DK FR GB**

(71) Applicant: **FLUKE CORPORATION**
**P.O. Box 9090**
**Everett,**
**Washington 98206-9090 (US)**

(72) Inventor: **Beckert, Richard D.**
**11620 127th Avenue N.E.**
**Lake Stevens, WA 98258 (US)**

(74) Representative: **Burke, Steven David et al**
**R.G.C. Jenkins & Co.**
**26 Caxton Street**
**London SW1H 0RJ (GB)**

(54) **Vibration monitoring apparatus with strobe trigger feature.**

(57) A device monitors the vibrations of a device under test and provides a signal for strobing a strobe light in response to a particular vibration mode. An input signal, representative of the vibrations of the device under test, is received by a processor and the processor selects a particular spectral component of the input signal representative of a corresponding vibrational mode. In response to each occurrence of a predefined phase state of the selected spectral component, the processor provides a strobing pulse. The pulse is coupled, via a strobe driver, to a strobe light that flashes in accordance with the pulse.

FIG. I

Background of the Invention

This invention relates generally to vibration test apparatus, and more particularly, to an apparatus capable of monitoring the vibrations of an object and triggering a strobe light accordance with a selected frequency component of the vibrations.

It is well known that vibration sensing equipment may be used to test the performance of certain types of devices or systems. It is also known that strobe lights may be included in the test equipment to facilitate the testing. Spin balancing equipment is an example of vibration test equipment that may be coupled to a strobe light for use in spin balancing wheels for vehicles, such as cars and trucks. According to one conventional technique used in the prior art, a wheel is placed on the test equipment and spun at high speed. A balanced wheel spins without appreciable vibration, while an unbalanced wheel will vibrate sufficiently to displace it from its axis of rotation. The test equipment typically includes a sensor that detects this displacement and causes a strobe light to flash in response to the displacement. The strobe flash "freezes" the wheel and allows the technician to determine where a balancing weight can be added. While this type of equipment detects vibrations that are harmonically related to the wheels' rotation it unfortunately does not detect non-harmonically related sources of vibration, such as may originate in the vehicle's engine, for example. Additionally, prior art spin balancing equipment usually consists of large, expensive and relatively stationary test stations. As a result, vehicles that need to have their wheels tested must be taken to a garage having one of these test stations.

Another prior art application of vibration test equipment and strobe lights includes monitoring the performance of machines, such a motors or generators, by aiming a strobe light at the machine's rotating shaft. If the technician knows the nominal speed of the machine (e.g., 3600 RPM) the strobe light can be set to flash at a corresponding rate. As the strobe light flashes, the shaft will appear stationary unless it is rotating at other than nominal speed. One disadvantage with these prior art strobe devices is that their rate is either manually set or is determined by the equipment being tested. In the case of a manually set strobe light whose rate is incorrectly selected, the test results will be meaningless and an equipment problem may go undetected. In some instances the flash rate may be determined by the equipment. For example, the strobe light may be connected into the control circuit of the motor or generator under test, whereby a control signal triggers the strobe light. Typically the strobe light is triggered in accordance with the control signal's fundamental frequency and cannot be triggered from any other frequency component of the signal. As a result, shaft speed variations due to a frequency component other than the fundamental may go unnoticed.

Accordingly, there is a need for an inexpensive, portable device capable of triggering a strobe light in accordance with a particular vibration source. The present invention, directed to an apparatus for monitoring vibration-related signals, selecting a particular frequency component of the signal and operating a strobe light in accordance with the selected frequency component, is designed to achieve these results.

Summary of the Invention

An apparatus for monitoring vibrations and triggering a strobe light includes input circuitry, a processor and a strobe driver. The input circuitry receives a vibration-related signal having a plurality of spectral components. The processor selects a frequency component of the vibration-related signal and provides a strobe signal that results in the triggering of a strobe light in accordance with the selected frequency component.

In accordance with further aspects of the present invention, an analog-to-digital converter samples the vibration-related signal at a predetermined rate and converts the sampled signal to digital data for processing by the processor. The processor includes a low pass decimation filter, a band pass filter and a peak detector. The low pass decimation filter removes data corresponding to high frequency components of the sampled input signal that would occur in the band of interest at the new Nyquist rate after decimation. The data corresponding to the low frequency components is then decimated permitting higher resolution of the lower frequencies. The output of the low pass decimation filter is band pass filtered to select a particular frequency component. The peak detector detects peak values of the frequency component passed by the band pass filter and generates the strobe signal in response thereto.

In accordance with yet further aspects of the present invention, the processor includes a time-frequency converter. The time-frequency converter converts the output of the low pass decimation filter from time domain data to frequency domain data and provides spectral information for the vibration-related signal to the display.

In accordance with still further aspects of the present invention, the strobe driver includes a current injection circuit couplable to the strobe light. In response to the strobe signal, the current injection circuit produces a current pulse capable of triggering the strobe light.

As will be appreciated from the foregoing summary, the present invention provides an apparatus for monitoring vibrations and triggering a strobe light in accordance with a selected frequency component of a vibration-related signal.

## Brief Description of the Drawings

FIG. 1 is a simplified block diagram of an apparatus according to the preferred embodiment of the present invention instrument for monitoring vibrations and triggering a strobe;

FIG. 2 is a block diagram illustrating important elements in a processor of the apparatus depicted in FIG. 1;

FIG. 3 is a combined schematic and block diagram illustrating a strobe driver of the apparatus depicted in FIG. 1 inductively coupled to a strobe;

FIG. 4 is a schematic diagram of pulse stretching and amplifying circuits of the strobe driver depicted in FIG. 3; and,

FIG. 5 is a flow chart of program illustrating broad functional steps executed by the processor depicted in FIG. 1

## Detailed Description of the Preferred Embodiment

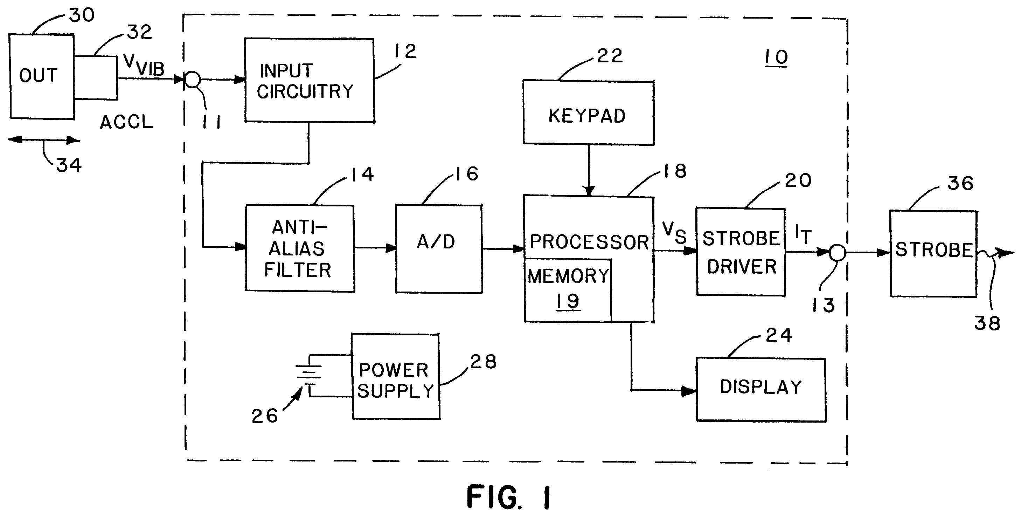

FIG. 1 illustrates a preferred embodiment of the present invention suitable for monitoring vibrations of an object and triggering a strobe. Apparatus 10 receives a vibration-related signal, $V_{VIB}$, from accelerometer 32, or other suitable transducer, coupled to a device under test (DUT) 30, the vibrations of which are represented by arrows 34. It is assumed that $V_{VIB}$ includes a plurality of frequency components related to vibrations 34 of DUT 30, as well as noise and other extraneous signals. As will become better understood from the following discussion, apparatus 10 selects a particular frequency component of the $V_{VIB}$ signal and generates a strobe trigger signal, $I_T$, in response to the selected frequency component. The $I_T$ signal may then be applied to strobe 36 so as to cause the strobe to operate (i.e., flash as represented by wary line 38) in accordance with the selected frequency component. As also will be discussed below, apparatus 10 preferably provides a graphical representation of spectral data for the vibration-related signal.

Apparatus 10 is preferably a portable, handheld electronic test tool that includes input terminals 11 for receiving the vibration-related signal ($V_{VIB}$), various components for processing the vibration-related signal, and output terminals 13 for presenting the strobe trigger signal ($I_T$) to strobe 36. A working model of apparatus 10 includes input circuitry 12, anti-alias filter 14, sampling analog-to-digital converter (A/D) 16, processor 18, strobe driver 20, key pad 22 and display 24. Input circuitry 12 is coupled to receive $V_{VIB}$ at input terminals 11. In the working model of apparatus 10, input circuitry 12 includes well known protection and conditioning circuitry for protecting the various components of apparatus 10 as well as providing appropriate gain conditioning for the $V_{VIB}$ signal. Anti-alias filter 14 filters the output of input circuitry 12 and provides a filtered signal to A/D 16, which samples the output signal from anti-alias filter 14 at a predetermined rate and converts the samples to digital information representative of the vibration-related signal for processing by processor 18. From the digital information, the processor selects a frequency component of the vibration-related signal for use in generating the strobe trigger signal. In accordance with the preferred embodiment of the present invention, processor 18 determines a maximum amplitude, either positive or negative, of the selected frequency component and generates a strobe signal in the form of a voltage pulse, $V_S$, in response to each occurrence of the maximum value. The voltage pulse is applied to strobe driver 20 which, in response thereto and as discussed below, produces the strobe trigger signal, $I_T$.

Anti-alias filter 14 is preferably an analog Butterworth or Bessel filter of low order and is designed such that non-linear phase is minimized in the frequency band of interest, i.e., the band having the desired frequency component for driving strobe 36. As will be discussed below, by oversampling and using appropriate digital, FIR, low-pass decimation filtering, the attenuation transition region of anti-alias filter 14 is easily positioned beyond the frequency band of interest.

As previously noted, apparatus 10 is preferably a portable, handheld device, and as such, includes power supply 28 and battery 26 coupled to provide power to the various components of the apparatus.

Processor 18 is preferably a commercially available digital signal processor such as the model DSP56001, manufactured by Motorola. Processor 18 includes memory 19 for storing program instructions, algorithms, filter coefficients, computed data and the like. Memory 19 is illustrated in FIG. 1 as being on-chip memory, that is, memory supplied as part of the digital signal processing chip forming processor 18. It is recognized and understood however that memory 19 may include off-chip memory, that is, discrete memory devices such as RAM and ROM chips that are separate from any chip(s) forming processor 18.

Processor 18 operates in accordance with a predetermined program to filter the digital data from A/D 16 for selecting a frequency component of the vibration-related signal. The predetermined program includes filter algorithms and coefficients for selecting a particular frequency component.

Processor 18 also operates according to the program to obtain frequency domain data for providing on display 24 a frequency domain representation of the vibration-related signal, $V_{VIB}$. Optional user inputs may be supplied to processor 18 via keypad 22 for identifying display and filter parameters.

Processor 18 preferably operates to decimate the digital samples supplied by A/D 16. Decimation reduces the amount of data that must be stored in memory 19. Decimation is desirable in situations in which data storage is limited because it permits increasing the frequency resolution of the collected data without increasing the memory requirements. Without decimation, it would be necessary to collect and store more data in order to obtain increased frequency resolution. In addition, oversampling followed by decimation eases the requirements of anti-alias filter 14, permitting the use of a simpler, lower order filter design.

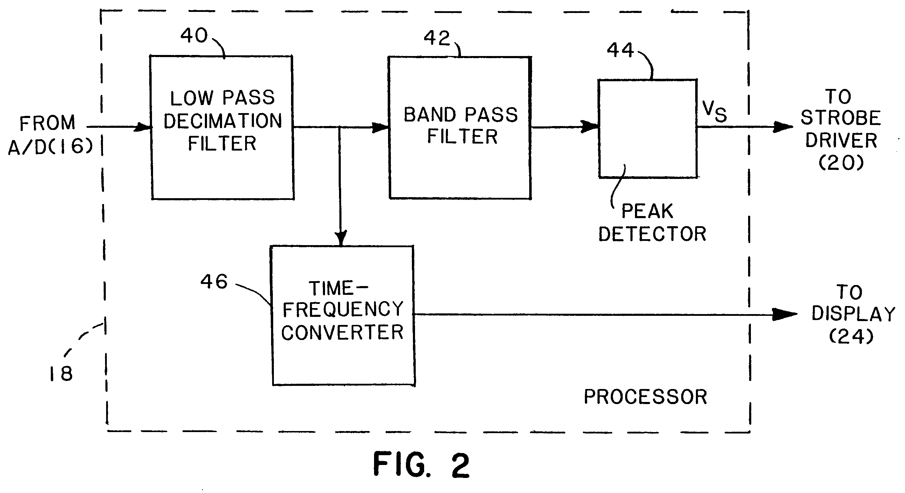

FIG. 2 illustrates various functional blocks of processor 18 which have been briefly mentioned above. As depicted in FIG. 2, processor 18 preferably includes low pass decimation filter 40, band pass filter 42, peak detector 44, and time-to-frequency converter 46. As previously discussed, processor 18 is preferably a digital signal processor. Accordingly, filters 40, 42, detector 44, and converter 46 represent functions performed in software, that is, by the processor in accordance with the instructions of a predetermined program.

The output of A/D 16 is applied to processor 18 and filtered by low pass decimation filter 40 which operates to low-pass filter the input and remove frequency components above the range of interest which could alias the resulting output of the low pass decimation filter. In addition filter 40 decimates the samples from A/D converter 16. According to a working model of the present invention, low pass decimation filter 40 decimates the digital signal by a factor of two, thereby effectively reducing the sampling rate of A/D 16 by a factor of two and increasing the frequency resolution of the data stored in memory. The Nyquist frequency of the decimated data is one-half the new effective sample rate. Therefore, low-pass filtering is included as part of the decimation process prior to decimation fob attenuating spectral components of the digital signal above the new Nyquist frequency limit so that, during decimation, the upper frequencies do not corrupt the lower frequency band of the decimated signal.

The output of low pass decimation filter 40 is filtered by band pass filter 42 for selecting a particular frequency component of the vibration-related signal, $V_{VIB}$. The selected frequency component is time domain information used for generating the strobe trigger signal. For example, if the user desires to trigger the strobe device at say 11 Hz, band pass filter 42 would be designed to pass only the 11 HZ component of the signal. Peak detector 44 detects peak values of the selected frequency component and generates signal pulse, $V_S$, in response thereto. Preferably, $V_S$ is generated with each detected peak value of the selected frequency component so as to cause strobe driver 20 to generate the strobe trigger signal ($I_T$) at the selected frequency (i.e., 11 Hz in the present example).

Preferably, the decimated output of low pass decimation filter 40 is also applied to time-to-frequency converter 46 which performs a Fast Fourier Transform operation, or other Fourier transform operation, on the data for generating frequency domain information of the vibration-related signal. The frequency domain information is presented to display 24 wherein a graphical representation of the spectral data of the vibration-related signal, $V_{VIB}$, is generated.

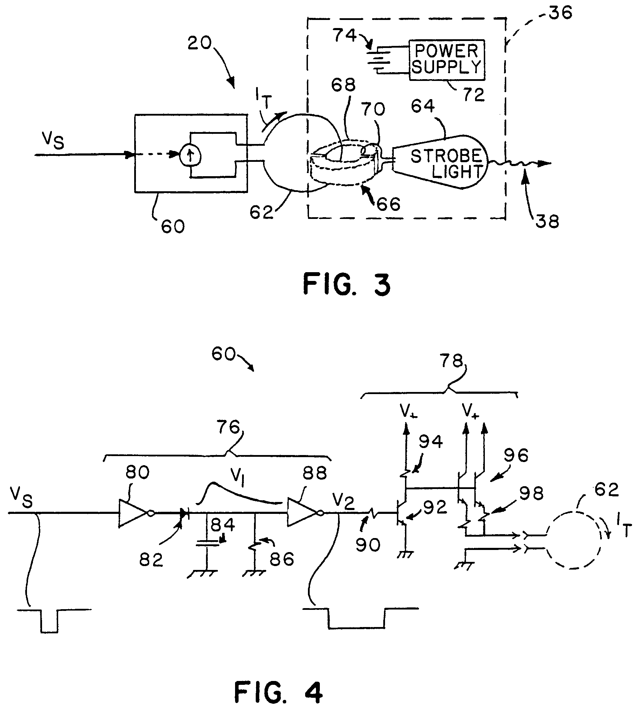

Referring to FIG. 3, strobe driver 20 includes a current injection circuit 60 coupled to wire loop 62. In a manner discussed below and illustrated in FIG. 4, current injection circuit 60 receives the voltage pulse, $V_S$, and converts it to strobe trigger signal, $I_T$, which is a current pulse having sufficient amplitude and duration for triggering strobe 36. $I_T$ is injected into wire loop 62 which is inductively coupled to strobe 36.

Strobes are available in a variety of configurations, including the configuration shown in FIG. 3, which includes strobe light 64 and inductive coupler 66. Power supply 72 supplies power to strobe light 64. While power supply 72 is shown as part of strobe 36, it is to be understood that the power supply may be separate from the strobe, such as is the case with a strobe connected to a car battery, for example. Inductive coupler 66 typically employs a ferrite core 68. According to the preferred embodiment, wire loop 62 passes through the center of ferrite core 68 and, hence, through the magnetic flux circuit of the inductive coupler. A secondary wire loop 70 couples the magnetic flux circuit of core 68 to the input of strobe light 64. In this fashion, the $I_T$ current pulse induces a current pulse on secondary wire loop 70, thereby triggering strobe light 64 and producing a flash of light 38.

Turning to FIG. 4, current injection circuit 60 is illustrated as comprising pulse stretching circuit 76 and output buffer 78. Pulse stretching circuit 76 includes Schmidt trigger inverter 80, diode 82, capacitor 84, resistor 86, and Schmidt trigger inverter 88. Inverter 80 inverts the narrow voltage pulse, $V_S$, and drives the anode of diode 82 for charging shunt capacitor 84 thereby producing voltage, $V_1$. Once the shunt capacitor is charged to the high logic input threshold of Schmidt trigger inverter 88, the inverter's output voltage, $V_2$, transitions from a

logic high to a logic low state. Following the narrow pulse, $V_S$, the voltage across shunt capacitor 84 and shunt resistor 86 ($V_1$) discharges through resistor 86 in accordance with RC time constant of capacitor 84 and resistor 86 (ignoring the input resistance and parasitic capacitance at the input of inverter 88. $V_1$ is applied to the input of inverter 88 and once $V_1$ drops below the low logic input threshold of inverter 88, the inverter's output voltage $V_2$ transitions from a logic low to a logic high state. Pulse stretching circuit 76 thus stretches and converts a narrow input pulse ($V_S$) to an output pulse ($V_2$) of longer duration in accordance with the hysteresis of inverter 88 and the RC time constant of capacitor 84 and resistor 86.

Output buffer 78 of FIG. 4 comprises first and second amplifying stages, the first stage comprising an inverting voltage amplifier which includes resistor 90, transistor 92 and resistor 94. Resistor 90 couples $V_2$ to the base of the common emitter transistor 92 and is operative for limiting the base current drawn from inverter 88 by transistor 92 when the output of the inverter is logic high. Transistor 92 is provided with a collector resistor 94 tied to an upper supply voltage $V^+$, wherein $V^+$ is greater than the supply voltage ($V_{CC}$) supplying the logic chips of inverters 80, 88.

The inverting amplifier is followed by the second stage current amplifier comprising two emitter follower transistors 96 connected in parallel, each having a current gain $\beta$ and an emitter resistor 98 coupled via wire loop 62 to ground. Emitter resistors 98 limit the current through transistors 96. The emitter followers, upon receiving a high voltage $V^+$ at the bases of transistors 96 from the collector of transistor 92, deliver current $I_T$ to wire loop 62 as set forth in the following equation:

$$I_T = \frac{2(\beta + 1)(V^+ - V_{be})}{2R_{94} + (\beta + 1) R_{98}}$$

where $\beta$ is the base-to-collector current gain of each transistor, $R_{94}$ is the value of resistor 94, $V_{be}$ is the base-to-emitter voltage of each transistor 96, and $R_{98}$ is the value of each resistor 98. Thus, current injection circuit 60 of FIG. 4 stretches $V_S$ and converts it to $I_T$ having a duration and magnitude sufficient to drive standard off-the-shelf strobe light devices, such as strobe 36.

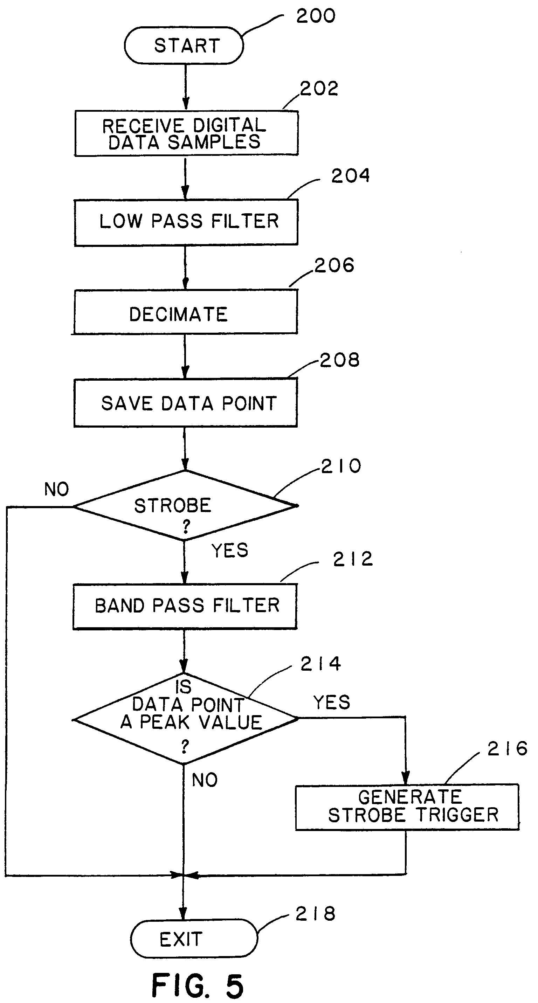

Turning to FIG. 5, a flow chart depicts broad functional steps of an interrupt program executed by processor 18 according to the preferred embodiment of the invention. The interrupt program is preferably executed in accordance with the sampling rate of A/D 16 for each data point sampled.

For example, if the A/D is operating at 20 kHz, then the interrupt program is executed every 50 microseconds.

The signal processing function of processor 18 begins at block 200 and proceeds to block 202 where the interrupt program instructs the processor to receive digital data samples one by one from A/D 16. The processor is next instructed at block 204 to low pass filter the data as it is received to remove data corresponding to frequency components above a particular frequency so as to prevent aliasing of the decimated data. Proceeding to block 206 the filtered data is decimated as it is received, for example, by a factor of two. In the example of decimation by two, every other data sample is retained for processing while the remaining data points are discarded. The decimated data points that are to be retained are saved at block 208. The data saved at block 208 is the data that will be used by the time-frequency converter 46 (FIG. 2) for generating spectral information on display 24 (FIG. 1).

Decision block 210 determines whether the strobe feature has been selected. According to a working model of the present invention, the user may select via key pad 22 (FIG. 1) whether to perform the strobing feature. If the strobing feature is not selected, the program precedes to block 218 and instructs the processor to exit the program. If the strobe feature is selected, the program proceeds to block 212 where the processor is instructed to apply a band pass filter to the decimated data (from block 206). During this step, a particular frequency, or band of frequencies, is selected to generate the strobe signal. Continuing to decision block 214 the processor is instructed to determine if the present data point is a peak value. The processor may initiate any number of algorithms to perform this step. According to the working model of the present invention, the processor compares the present data point value to the values of two adjacent points on either side of the present data point. If the present data point value is greater than the four adjacent point values (two on each side), the present data point is considered a peak value and the program proceeds to block 216 and instructs the processor to generate a strobe signal ($V_S$). Once the instruction is given to generate the strobe signal or if the present data point is not a peak value, the program instructs the processor to exit the program at block 218. This process is repeated for each data sample.

The apparatus according to the present invention thus provides a trigger signal for operating a strobe in accordance with a given spectral component of a vibration-related signal. The architecture of the present invention as described above for signal acquisition, filtering and processing is well suited for providing a versatile, compact and accurate strobing vibration tool to be used by technicians, engineers and scientists in the field for assisting identification and trouble shooting of vibration problems such as an unbalanced wheel of an automobile, or more complicated problems such as destructive vibration of industrial machinery or the vibration of an airplane in response to a beat frequency between two separately rotating turbines. Many other advantages and uses will become apparent to those skilled in the art.

While a preferred embodiment of the present invention has been shown and described, it will be apparent to those skilled in the art that many changes and modifications may be made without departing from the invention in its broader aspects. For example, if sufficient memory exists and if speed requirements are not critical, the invention could be practiced without decimating the sampled data. Likewise, higher order analog filtering could be used, at a correspondingly higher cost, to reduce digital filtering requirements. Similarly, a general purpose microprocessor could be substituted for the dedicated digital signal processor with, of course, an appreciable, reduction, in processing efficiency. Consequently, the invention can be practiced otherwise than as specifically described herein.

## Claims

1. An apparatus for triggering a strobe light, said apparatus comprising processing means for receiving an input signal comprising a plurality of spectral components, and configured to provide a strobe signal for triggering said strobe light in accordance with a predetermined spectral component of said plurality of spectral components.

2. An apparatus according to claim 1 wherein said processing means includes:
   (a) digital signal processing means for receiving said input signal and processing said input signal in accordance with processing instructions; and,
   b) memory means programmed for providing the processing instructions for instructing said digital signal processing means to select said predetermined spectral component and provide said strobe signal representative thereof.

3. An apparatus according to claim 1 further comprising means for strobing said strobe light in accordance with said strobe signal.

4. An apparatus for triggering a strobe light, said apparatus comprising:
   (a) input means for receiving an input signal having a plurality of spectral components;
   (b) processing means for selecting a spectral component of the input signal and providing a strobe signal representative of the selected spectral component; and,
   (c) strobing means triggering said strobe light in accordance with the strobe signal.

5. An apparatus according to claim 4 further comprising:
   (a) filtering means for filtering the input signal, said filtering means having a low-pass frequency response greater than two times the upper most frequency in the band of interest;
   (b) converter means for converting the filtered input signal to a digital format for providing a digital signal comprising data samples of a sample rate greater than two times the upper most frequency in the band of interest; and,
   (c) wherein said processing means includes digital signal processing means for digitally filtering the digital signal for selecting said spectral component, and providing, as said strobe signal, sequential trigger events coherent with the filtered signal.

6. An apparatus according to claim 5 wherein the trigger events provided are pulses of a predetermined polarity and duration.

7. An apparatus according to claim 5 wherein said digital signal processing means is further operative for decimating the digital signal for enhancing spectral resolution before selecting said spectral component.

8. An apparatus according to claim 7 wherein said digital signal processor provides the decimation with low pass filtering for preventing unwanted higher frequency components of the digital signal from aliasing the resulting decimated signal, said low pass decimation filtering having a low-pass frequency response cut-off frequency defined according to Nyquist's criteria and the equivalent sampling rate of the decimated signal.

9. An apparatus according to claim 4 further comprising interfacing means for receiving a control input, said processing means being operative for selecting said spectral component in accordance with the control input.

**10.** An apparatus according to claim 9 wherein:

(a) said processing means is further operative for determining a plurality of spectral components of the input signal; and,

(b) said strobing means further includes display means for reporting the determined spectral components, thereby allowing an operator to provide said control input in accordance with the reported spectral components.

**11.** A strobing vibrational meter for measuring vibrations of a device under test and triggering a strobe light for illuminating the device under test in accordance with said vibrations, said meter comprising:

(a) an input terminal for receiving a measurement signal representative of the vibrations of said device under test;

(b) processing means for determining and reporting the frequency components of the measurement signal, filtering the measurement signal for selecting a predetermined spectral component of the measurement signal, and providing a strobe signal in accordance with the filtered measurement signal; and,

(c) strobe driver means for triggering said strobe light to flash according to the strobe signal.

**12.** A meter according to claim 1 further comprising:

(a) a transducer coupled to said device under test for providing said measurement signal in response to the vibrations of said device under test; and,

(b) means for coupling said measurement signal from the transducer to said input.

**13.** A meter according to claim 12 wherein the strobe driver means includes:

(a) a wire loop inductively coupled to said strobe light; and,

(b) a circuit for injecting, in response to said strobing signal, a current pulse to the wire loop for triggering, via the inductive coupling, a strobe light flash.

**14.** A strobe meter for observing a device under test, comprising an input for receiving a signal, an adjustable band-pass filter coupled to the input for providing a selected one of a plurality of frequency components of the input signal, and means responsive to the selected frequency component for driving a strobe light in synchronism therewith.

FIG. I

FIG. 2

EP 0 671 611 A2

FIG. 3

FIG. 4

START — 200

RECEIVE DIGITAL
DATA SAMPLES — 202

LOW PASS FILTER — 204

DECIMATE — 206

SAVE DATA POINT — 208

STROBE ? — 210
NO
YES

BAND PASS FILTER — 212

IS
DATA POINT
A PEAK VALUE ? — 214
YES
NO

GENERATE
STROBE TRIGGER — 216

EXIT — 218

FIG. 5